# FASCICULE DE BREVET EUROPEEN

(11) **EP 1 525 624 B1**
(45) Date de publication et mention de la délivrance du brevet: **28.03.2018**
(21) Numéro de dépôt: 03750840.5
(22) Date de dépôt: 24.07.2003
(51) Int. Cl.: H01L 31/108

(54) **DISPOSITIF DE PHOTODÉTECTION DE TYPE MSM ET À CAVITE RÉSONNANTE COMPRENANT UN MIROIR À RÉSEAU D'ÉLECTRODES METALLIQUES**
MSM FOTOEMPFANGENDE VORRICHTUNG MIT EINEM RESONANZHOHLRAUM, DIE EINEN SPIEGEL AUS EINER METALLISCHEN ELEKTRODENANORDNUNG AUFWEIST
MSM-TYPE PHOTODETECTOR DEVICE WITH RESONANT CAVITY COMPRISING A MIRROR WITH METAL ELECTRODE GRATING

(30) Priorité: 25.07.2002 FR 0209430
(43) Date de publication de la demande: 27.04.2005
(73) Titulaire: CENTRE NATIONAL DE LA RECHERCHE SCIENTIFIQUE -CNRS-, 75794 Paris Cedex 16 (FR)
(72) Inventeur: PARDO, Fabrice, F-94400 Vitry sur Seine (FR); COLLIN, Stéphane, F-75015 Paris (FR); PELOUARD, Jean-Luc, F-75020 Paris (FR)
(74) Mandataire: Regimbeau
(86) Numéro de dépôt international: PCT/FR2003/002343
(87) Numéro de publication internationale: WO 2004/012275

(56) Documents cités:
- EP-A- 0 651 448
- FR-A- 2 803 950
- US-A- 5 227 648
- US-A- 5 663 639
- STRITTMATTER A ET AL: "High-frequency, Long-wavelength Resonant-cavity Enhanced Ingaas Msm Photodetectors" 22ND EUROPEAN CONFERENCE ON OPTICAL COMMUNICATION ECOC' 96, vol. 1, 15 septembre 1996 (1996-09-15), pages 145-148, XP010303054 Oslo
- STRITTMATTER A ET AL: "High speed, high efficiency resonant-cavity enhanced InGaAs MSM photodetectors" ELECTRONICS LETTERS, IEE STEVENAGE, GB, vol. 32, no. 13, 20 juin 1996 (1996-06-20), pages 1231-1232, XP006005324 ISSN: 0013-5194
- KISHINO K ET AL: "RESONANT CAVITY-ENHANCED (RCE) PHOTODETECTORS" IEEE JOURNAL OF QUANTUM ELECTRONICS, IEEE INC. NEW YORK, US, vol. 27, no. 8, août 1991 (1991-08), pages 2025-2034, XP001090922 ISSN: 0018-9197
- KOWALSKY W ET AL: "HIGH BANDWIDTH METAL-SEMICONDUCTOR-METAL PHOTODIODES WITH INTEGRATED FABRY-PEROT RESONATOR FOR WDM RECEIVERS" EXTENDED ABSTRACTS OF THE INTERNATIONAL CONFERENCE ON SOLID STATE DEVICES AND MATERIALS, JAPAN SOCIETY OF APPLIED PHYSICS. TOKYO, JA, 1 août 1992 (1992-08-01), pages 214-216, XP000312201

## Description

### DOMAINE TECHNIQUE

La présente invention se rapporte à un dispositif de photodétection de type MSM et à cavité résonnante comprenant un miroir à réseau d'électrodes.

### ETAT DE LA TECHNIQUE ANTERIEURE

Un photodétecteur ultra-rapide (temps de réponse inférieur à 1ps) est aujourd'hui un élément crucial pour les télécommunications à très haut débit par fibre optique (100 Gbits/s et au delà). Les performances recherchées sont une grande sensibilité et une large bande passante dans les longueurs d'onde de 1,3 et 1,55 µm. Quel que soit le type de photodétecteur (diode PN, diode PIN, structure Métal-Semiconducteur-Métal ou MSM), l'objectif de rapidité impose que la distance inter-électrodes soit courte (inférieure à 100 nm) et que la lumière soit absorbée dans un volume minimal.

Les photodétecteurs existant actuellement font donc nécessairement l'objet d'un compromis entre rendement et vitesse. Ainsi, le semiconducteur InGaAs massif ayant une longueur caractéristique d'absorption d'environ 3 µm, à la longueur d'onde de 1,55 µm, la diminution du temps de transit des porteurs de charge est directement liée à une diminution du rendement quantique externe dans les diodes PIN et dans les structures MSM.

En utilisant les photorépéteurs actuels, la montée en débit des télécommunications optiques imposerait donc une augmentation importante du nombre de répéteurs sur la ligne de transmission et donc son coût.

Les photodétecteurs MSM ultrarapides (plusieurs centaines de GHz) doivent avoir une couche absorbante de faible épaisseur et un espace inter-électrodes inférieur à la longueur d'onde.

La première contrainte limite fortement la sensibilité comme il ressort de l'article "High-Speed InGaAs Metal-Semiconductor-Metal Photodetectors with Thin Absorption Layers" de W.A. Wohlmuth et al., IEEE Photon. Tech. Lett., Vol.9, N°5, 1997, pages 654 à 656.

La deuxième contrainte limite également fortement la sensibilité. Elle est référencée dans la littérature sous deux aspects : d'une part, un effet d'ombrage des électrodes et d'autre part, un effet de diffraction conduisant à une faible pénétration de la lumière dans le dispositif. On peut se reporter à ce sujet à l'article "High-Responsivity InGaAs MSM Photodetectors with Semi-Transparent Schottky Contacts" de R.H. Yuang et al., IEEE Photon. Tech. Lett., Vol.7, N°11, 1995, pages 1333 à 1335.

Pour contourner cette difficulté, les recherches s'orientent dans deux directions différentes. Les photodiodes PIN ou Schottky associées à une cavité résonante permettent de conserver un rendement quantique élevé, mais leur fréquence de coupure est limitée à environ 100 GHz pour des dispositifs de 100 µm² de surface. On peut se reporter à ce sujet à l'article "Resonant Cavity-Enhanced (RCE) Photodetectors" de K. Kishino et al., IEEE J. Quantum Electron., Vol.78, N°2, 1995, pages 607 à 639.

Plus récemment, des photodétecteurs à ondes propagatives ont été étudiés. Contrairement aux structures précédentes, l'éclairage est latéral, c'est-à-dire perpendiculaire au déplacement des porteurs de charge. Ces structures sont conçues pour être à la fois un guide d'onde optique et un guide d'onde électrique TEM. La limitation due à la capacité (constante de charge RC) est alors remplacée par une limitation due au désaccord entre les vitesses de groupe optique et électrique. On peut se reporter à ce sujet à l'article "Traveling-Wave Photodetectors" de K.S. Giboney et al., IEEE Photon. Techn. Lett., Vol.4, N°12, 1992, pages 1363 à 1365.

L'article "High-frequency, long wavelength resonant-cavity-enhanced InGaAs MSM photodetectors" de A. Strittmatter et al., 22nd European Conference on Optical Communication - ECOC'96, Oslo, divulgue un photodétecteur de type MSM à cavité résonante.

### EXPOSÉ DE L'INVENTION

Pour remédier aux inconvénients des dispositifs de l'art antérieur, il est proposé selon la présente invention de concentrer de façon résonnante la lumière dans une structure MSM de faible volume actif. La résonance est de type Fabry-Pérot entre un miroir de haute réflectivité (par exemple un miroir de Bragg) à la base du dispositif et un réseau d'électrodes métalliques en surface. La période du réseau d'électrodes est inférieure à la longueur d'onde de la lumière incidence. La réflectivité de ce réseau d'électrodes (deuxième miroir de la cavité Fabry-Pérot) est contrôlée par les paramètres géométriques du réseau. La cavité ainsi réalisée comporte deux parties : une couche absorbante d'épaisseur réduite où sont générés les photo-porteurs et une couche non absorbante. La faible longueur des trajets que doivent parcourir les photo-porteurs pour être collectés par les électrodes assure à ce dispositif un comportement intrinsèque extrêmement rapide (temps de réponse inférieur à la picoseconde) alors que le couplage résonant avec la lumière incidente lui assure un rendement quantique externe élevé (typiquement 10 fois supérieur aux meilleures performances actuelles).

L'invention a donc pour objet un dispositif de photodétection de type MSM destiné à détecter une lumière incidente et comprenant, en superposition sur une première face d'un support, des moyens réfléchissants formant un premier miroir pour une cavité résonnante de type Fabry-Pérot, une couche d'un matériau n'absorbant pas ladite lumière, une couche active en matériau semiconducteur absorbant la lumière incidente et un réseau d'électrodes de polarisation et de collecte du signal détecté, le réseau d'électrodes étant disposé sur la couche active, le réseau d'électrodes étant constitué de bandes conductrices parallèles régulièrement espacées selon une période inférieure à la longueur d'onde de la lumière incidente, le réseau d'électrodes constituant un deuxième miroir pour la cavité résonnante, les caractéristiques optiques de ce deuxième miroir étant déterminées par les dimensions géométriques desdites bandes conductrices, la distance séparant le premier miroir du deuxième miroir étant déterminée pour obtenir entre ces deux miroirs une résonance de type Fabry-Pérot pour la lumière incidente.

Les moyens réfléchissants formant un premier miroir peuvent être constitués par un miroir de Bragg, par exemple constitué de couches alternées d'AlAs et d'AlGaAs ou de couches alternées de GaInAsP et d'InP ou de couches alternées d'AlGaInAs et d'AlInAs ou de couches alternées d'AlGaAsSb et d'AlAsSb.

Ils peuvent aussi être constitués par une couche métallique. De préférence, la couche métallique constituant le premier miroir offre une surface en argent, en or ou en aluminium à la lumière incidente.

Ils peuvent encore être constitués par un miroir diélectrique multicouche.

La couche de matériau n'absorbant pas la lumière peut être en AlₓGa₁₋ₓAs et la couche active en GaAs. De préférence, x est de l'ordre de 0,35 pour un fonctionnement à une longueur d'onde proche de 800 nm.

La couche de matériau n'absorbant pas la lumière peut aussi être en AlInAs et la couche active en InGaAs pour un fonctionnement à une longueur d'onde proche de 1500 nm.

Le réseau d'électrodes peut former deux peignes interdigités. En variante, le réseau d'électrodes peut être constitué desdites bandes conductrices qui sont juxtaposées et branchées en potentiel flottant.

Avantageusement, les bandes conductrices sont en argent ou en or.

Une couche de matériau diélectrique de passivation peut être déposée sur le réseau d'électrodes, par exemple une couche de dioxyde de silicium ou de nitrure de silicium.

Eventuellement, une deuxième face du support supporte une électrode d'application d'un champ électrique au dispositif pour changer, par effet électro-optique, la longueur d'onde de résonance de la cavité résonnante.

### BREVE DESCRIPTION DES DESSINS

L'invention sera mieux comprise et d'autres avantages et particularités apparaîtront à la lecture de la description qui va suivre, donnée à titre d'exemple non limitatif, accompagnée des dessins annexés parmi lesquels :
- la figure 1 est une vue partielle, en perspective et en coupe d'un dispositif de photodétection selon la présente invention,
- les figures 2 et 3 sont des vues de dessus d'un dispositif de photodétection selon la présente invention, dans une variante interdigitée,
- les figures 4A à 4F illustrent la réalisation d'un réseau d'électrodes et des contacts associés pour un dispositif de photodétection selon la présente invention,
- les figures 5A à 5C illustrent des étapes d'un procédé de réalisation d'un autre dispositif de photodétection selon la présente invention.

### EXPOSE DETAILLE DE MODES DE REALISATION PARTICULIERS

La structure proposée par la présente invention est constituée d'un réseau d'électrodes métalliques disposé sur une fine couche de matériau semiconducteur absorbant la lumière à détecter, cette fine couche étant elle-même déposée sur une couche transparente, elle-même déposée sur un miroir inférieur. L'invention exploite, d'une part, une transmission partielle des ondes incidentes (en polarisation TE et TM) à travers le réseau d'électrodes qui joue le rôle d'un miroir semi-réfléchissant (miroir supérieur) et, d'autre part, une résonance entre les miroirs supérieur et inférieur. Une très grande partie de la lumière incidente peut alors être absorbée très près des électrodes, dans la couche active qui peut faire 50 nm d'épaisseur.

La présence d'une couche de passivation déposée sur le réseau d'électrodes impose une légère modification des paramètres du réseau ainsi que de la distance entre les deux miroirs, sans remettre en cause l'existence des résonances mises à profit dans l'invention.

Une troisième électrode, placée sur la face arrière du dispositif, permet, en appliquant un champ électrique perpendiculaire à sa surface, de changer par effet électro-optique la longueur d'onde de la résonance et donc de servir à accorder le photodétecteur à la longueur d'onde.

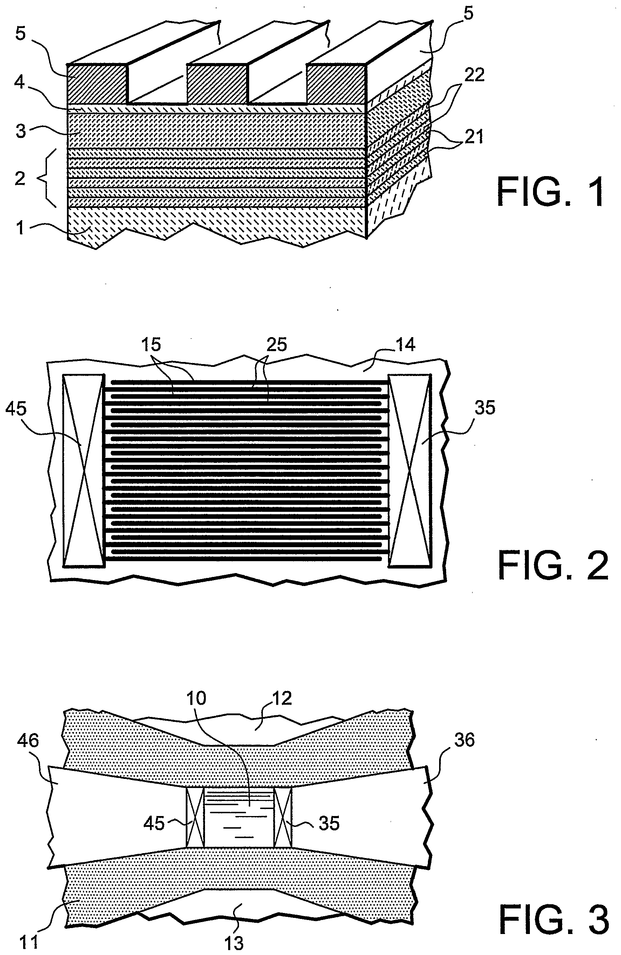

La figure 1 est une vue partielle, en perspective et en coupe d'un dispositif de photodétection selon la présente invention. Le dispositif de photodétection est réalisé à partir d'un substrat 1 en GaAs. La référence 2 désigne le miroir inférieur qui est ici un miroir de Bragg. Ce miroir de Bragg est constitué d'un empilement alterné de couches 21 et 22 en matériaux n'absorbant pas la lumière et d'indices de réfraction différents. Avec un substrat en GaAs, le miroir de Bragg peut être une alternance de couches d'AlAs et d'AlGaAs. Les épaisseurs de ces couches sont calculées en fonction de la gamme de longueurs d'onde à réfléchir. Les couches 21 et 22 peuvent être obtenues par épitaxie (par exemple par épitaxie par jet moléculaire) sur le substrat 1.

On dépose ensuite successivement sur le miroir inférieur 2 une couche 3 n'absorbant pas la lumière à détecter et une couche active 4. Ces couches peuvent aussi être déposées par épitaxie. La couche 3 peut être en AlₓGa₁₋ₓ As avec un coefficient x choisi de manière optimale égal à 0,35. La couche active 4 peut alors être en GaAs. Elle supporte un réseau d'électrodes 5 en or, en argent ou en aluminium. Les électrodes 5 sont constituées de bandes parallèles régulièrement espacées. Les dimensions géométriques des bandes sont choisies pour conduire à la formation, à l'interface entre le réseau d'électrodes 5 et la couche active 4, du miroir supérieur.

A titre d'exemple, pour une longueur d'onde de la lumière incidente d'environ 790 nm, la distance séparant les miroirs inférieur et supérieur peut être de 70 nm dont 40 nm de couche absorbante et 30 nm de couche transparente, la période du réseau d'électrodes peut être de 200 nm et les bandes conductrices peuvent avoir une largeur de 100 nm pour une épaisseur de 30 nm.

Cette structure diffère des structures MSM résonnantes proposées jusqu'à présent parce que le fait, selon l'invention, de rapprocher les électrodes ne présente plus l'inconvénient de masquer la lumière mais joue un rôle fondamental pour le contrôle de la réflectivité du miroir supérieur.

Si on s'intéresse à l'intensité de la composante électrique du champ électromagnétique dans la couche absorbante pour une lumière incidente reçue, on constate que l'absorption est très favorable à la collection des porteurs en polarisation TE puisqu'elle se fait principalement entre les électrodes, minimisant ainsi le temps de collection des photo-porteurs. En polarisation TM, le champ électromagnétique est localisé dans une région de faible champ électrique statique, ce qui est défavorable à une collection rapide des photo-porteurs.

La géométrie des électrodes peut être de type interdigité comme le montre la figure 2 qui est une vue de dessus d'un dispositif selon l'invention. Le réseau d'électrodes est disposé sur la couche active 14. Il est constitué de bandes parallèles 15 connectées électriquement à un contact commun 35, pour former un premier peigne, et de bandes parallèles 25 connectées électriquement à un autre contact commun 45, pour former un deuxième peigne. Les deux peignes sont interdigités. Dans cet exemple, la surface couverte par le réseau d'électrodes est de 5 µm x 5 µm.

La figure 3 est également une vue de dessus où le dispositif illustré par la figure 2 est désigné sous la référence 10. Il est réalisé sur un substrat référencé 11. On reconnaît les contacts 35 et 45. Les bandes métalliques (référencées 15 et 25 sur la figure 2) n'ont pas été représentées.

La figure 3 montre des pistes conductrices 36 et 46 connectant respectivement les contacts 35 et 45 et déposées sur le substrat 11. Le substrat 11 supporte aussi des métallisations 12 et 13 encadrant le dispositif de photodétection 10 et les pistes conductrices 36 et 46. L'ensemble des pistes métalliques 12, 13 et 46 d'une part et 12, 13 et 36 d'autre part forment des lignes coplanaires à impédance contrôlée pour une propagation du signal de photocourant produit.

Les électrodes peuvent aussi être constituées par une juxtaposition de bandes conductrices à potentiel flottant comme cela est décrit dans le document FR-A-2 803 950.

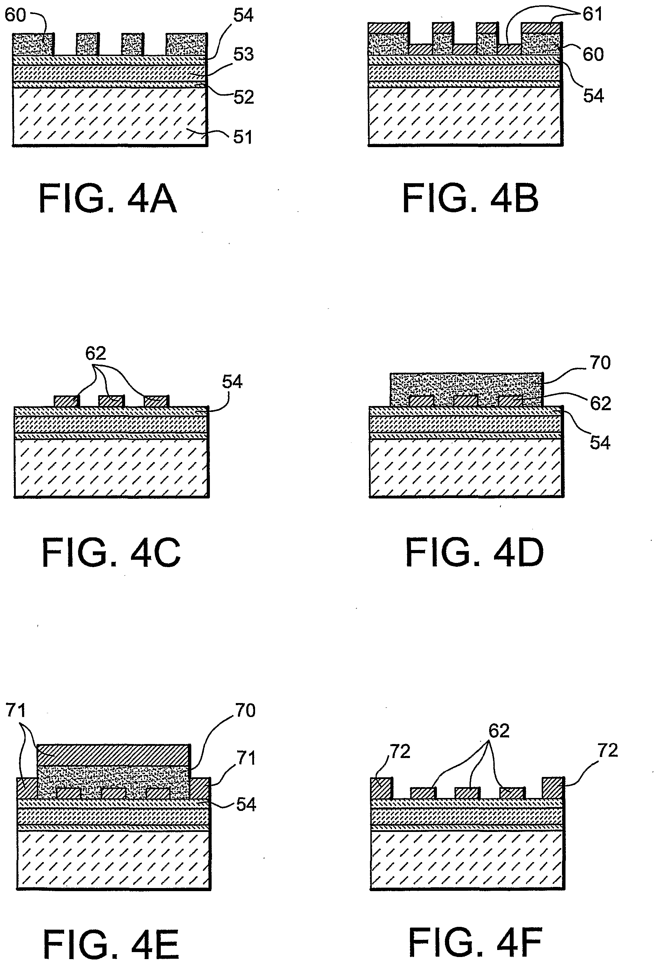

Les figures 4A à 4F illustrent la réalisation d'un réseau d'électrodes et des contacts associés pour un dispositif de photodétection selon la présente invention. Ces figures sont des vues en coupe transversale comme pour la figure 1.

La figure 4A montre un substrat 51 supportant successivement un miroir inférieur 52, une couche non absorbante 53 et une couche active 54. Si le substrat est en GaAs, le miroir inférieur peut être un miroir de Bragg constitué d'une alternance de couches d'AlAs et d'AlGaAs. (8 ou 16 paires de couches), la couche non absorbante est une couche d'AlₓGa₁₋ₓAs et la couche active est une couche de GaAs. Une couche 60 de polyméthacrylate de méthyle ou PMMA de 100 nm d'épaisseur a été déposée sur la couche active 54. Par lithographie électronique, des ouvertures sont pratiquées dans la couche 60 jusqu'à atteindre la couche active 54 en vue de réaliser le réseau d'électrodes. Ces ouvertures peuvent donc avoir 100 nm de largeur.

Une couche d'argent ou d'or est ensuite déposée sur la couche de PMMA gravée et selon une épaisseur de 30 nm. Cette couche d'argent ou d'or est représentée sous la référence 61 sur la figure 4B. Elle repose sur la couche 60 subsistante et sur les parties de la couche active 54 qui ont été révélées par la gravure.

On effectue ensuite une opération de "lift-off" par dissolution de PMMA dans du trichloroéthylène. Le résultat obtenu est présenté à la figure 4C. La couche active 54 supporte un réseau d'électrodes représenté sous la référence globale 62.

Une couche de résine 70 est ensuite déposée sur la couche active 54 supportant le réseau d'électrode 62. Une opération de lithographie optique permet de graver la couche de résine 70 jusqu'à révéler la couche active 54 aux endroits prévus pour les emplacements des contacts associés aux électrodes. C'est ce que montre la figure 4D.

On passe ensuite à la figure 4E qui montre qu'une couche 71, du même métal que le réseau d'électrodes ou d'un autre métal, a été déposée sur la couche de résine 70 subsistante et sur les parties de la couche active 54 qui ont été révélées par la gravure. La couche 71 est plus épaisse que la couche 61 (voir la figure 4B).

On procède ensuite à une nouvelle opération de "lift-off" pour obtenir la structure représentée à la figure 4F. la référence 72 désigne les contacts associés au réseau d'électrodes 62.

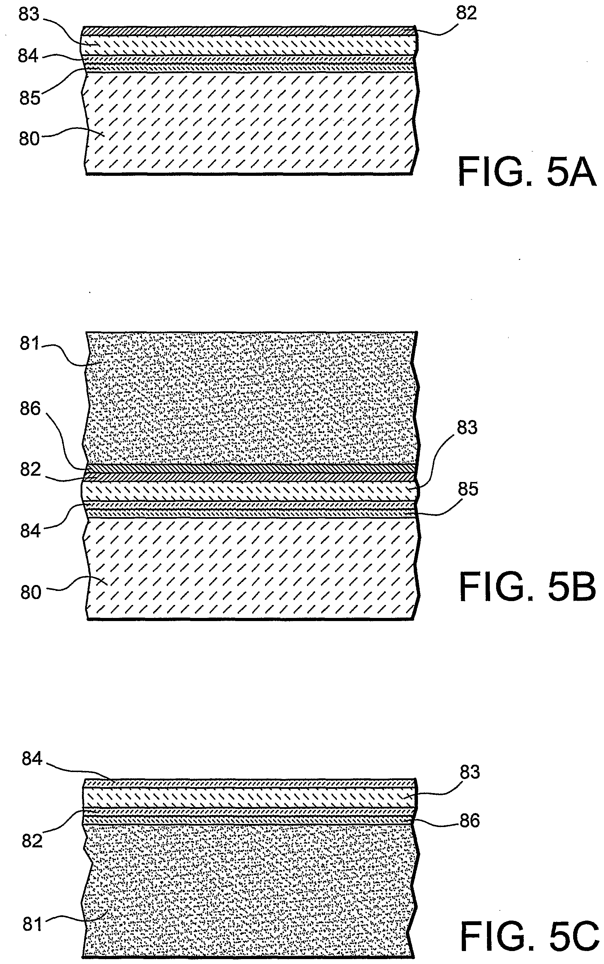

Les figures 5A à 5C illustrent des étapes d'un procédé de réalisation d'un autre dispositif de photodétection selon la présente invention. Dans cette variante, le miroir inférieur est constitué par une couche métallique. Ces figures sont des vues en coupe transversale comme pour la figure 1.

La figure 5A montre un substrat semiconducteur 80 supportant successivement une couche d'arrêt 85, une couche active 84, une couche non absorbante 83 et une couche métallique 82 destinée à constituer le miroir inférieur. Si le substrat 80 est en GaAs, la couche d'arrêt 85 peut être en GaInP, la couche active 84 peut être en GaAs et la couche non absorbante 83 peut être en AlₓGa₁₋ₓAs. La couche métallique 82 peut être un bicouche comprenant une première sous-couche en argent adjacente à la couche non absorbante 83. La couche métallique comprend également une deuxième sous-couche destinée à une brasure ultérieure et constituée, par exemple, d'un alliage d'or et de germanium. Le miroir inférieur peut aussi être un miroir diélectrique multicouche.

La figure 5B montre la structure précédente rendue solidaire d'un support 81. La solidarisation a été obtenue par une brasure réalisée entre la couche métallique 82 et une couche de brasure 86 déposée sur le support 81. Le support 81 peut être en tout matériau compatible avec le procédé mis en oeuvre.

Le substrat 80 est ensuite éliminé par polissage mécanique, mécano-chimique et chimique jusqu'à atteindre la couche d'arrêt 85. La couche d'arrêt 85 est ensuite elle-même éliminée par gravure chimique sélective pour exposer la couche active 84. C'est ce que montre la figure 5C.

La suite du procédé, pour obtenir le réseau d'électrodes et ses contacts associés, a déjà été décrit en association avec les figures 4A à 4F.

La nouvelle structure MSM proposée par la présente invention, comprenant une cavité résonante entre miroir de Bragg et un réseau métallique "sub-longueur d'onde" en or permet d'absorber plus de 50% de la lumière incidente (pour une longueur d'onde de 0,8 µm) dans une couche active de 40 nm d'épaisseur et avec un espace inter-électrode inférieur à 100 nm. Le rendement est ainsi 25 fois supérieur à celui obtenu par un unique passage à travers la couche absorbante. Ce rendement peut être sensiblement amélioré par l'utilisation d'un réseau en argent, en améliorant la réflectivité du miroir de Bragg et en augmentant l'épaisseur de la couche absorbante.

Le rendement quantique, externe obtenu sur un dispositif expérimental et en polarisation TE est de 15 % dans une couche de 40 nm d'épaisseur. Aucune difficulté technologique ne semble s'opposer à l'obtention de rendements supérieurs à 50 %.

La présente invention peut également être utilisée pour tout type de photodétecteur utilisant une cavité résonnante. Le réseau d'électrodes métalliques sert à la fois de miroir à la cavité et de moyen de polarisation électrique du détecteur. Par exemple, le dispositif peut être un détecteur de type PIN composé d'un empilement de couches semiconductrices de type p et n formant la jonction PN et incorporant une zone intrinsèque (zone I), l'empilement étant placé dans la cavité résonnante composée, par exemple, d'un miroir de Bragg et d'un miroir à réseau d'électrodes métalliques, ce réseau servant également à la polarisation d'une des couches p ou n de la jonction. Le dispositif peut aussi être un détecteur de type Schottky composé d'une couche semiconductrice non absorbante placée entre un miroir de Bragg et un réseau d'électrodes métalliques servant à la fois de miroir à la cavité, d'électrodes de polarisation électrique et de zone absorbante.

## Revendications

1. Dispositif de photodétection de type MSM destiné à détecter une lumière incidente et comprenant, en superposition sur une première face d'un support (1, 51, 81), des moyens réfléchissants (2, 52, 82) formant un premier miroir pour une cavité résonnante de type Fabry-Pérot, une couche d'un matériau n'absorbant pas ladite lumière (3, 53, 83), une couche active (4, 54, 84) en matériau semiconducteur absorbant la lumière incidente et un réseau d'électrodes de polarisation et de collecte du signal détecté, le réseau d'électrodes (5, 62) étant disposé sur la couche active, le réseau d'électrodes (5, 62) constituant un deuxième miroir pour la cavité résonnante, **caractérisé en ce que** le réseau d'électrodes est constitué de bandes conductrices parallèles régulièrement espacées selon une période inférieure à la longueur d'onde de la lumière incidente, la lumière à détecter est incidente au dispositif à travers le réseau d'électrodes, les caractéristiques optiques de ce deuxième miroir sont déterminées par les dimensions géométriques desdites bandes conductrices, la distance séparant le premier miroir du deuxième miroir étant déterminée pour obtenir entre ces deux miroirs une résonance de type Fabry-Pérot pour la lumière incidente.

2. Dispositif de photodétection selon la revendication 1, **caractérisé en ce que** les moyens réfléchissants formant un premier miroir sont constitués par un miroir de Bragg (2, 52).

3. Dispositif de photodétection selon la revendication 2, **caractérisé en ce que** le miroir de Bragg (2, 52) est constitué de couches alternées d'AlAs et d'AlGaAs ou de couches alternées de GaInAsP et d'InP ou de couches alternées d'AlGaInAs et d'AlInAs ou de couches alternées d'AlGaAsSb et d'AlAsSb.

4. Dispositif de photodétection selon la revendication 1, **caractérisé en ce que** les moyens réfléchissants formant un premier miroir sont constitués par une couche métallique (82).

5. Dispositif de photodétection selon la revendication 4, **caractérisé en ce que** la couche métallique (82) constituant le premier miroir offre une surface en argent, en or ou en aluminium à la lumière incidente.

6. Dispositif de photodétection selon la revendication 1, **caractérisé en ce que** les moyens réfléchissants formant un premier miroir sont constitués par un miroir diélectrique multicouche.

7. Dispositif de photodétection selon la revendication 1, **caractérisé en ce que** la couche de matériau n'absorbant pas la lumière (3, 53, 83) est en AlₓGa₁₋ₓAs et la couche active (4, 54, 84) est en GaAs.

8. Dispositif de photodétection selon la revendication 7, **caractérisé en ce que** x est de l'ordre de 0,35.

9. Dispositif de photodétection selon la revendication 1, **caractérisé en ce que** la couche de matériau n'absorbant pas la lumière (3, 53, 83) est en AlInAs et la couche active (4, 54, 84) est en InGaAs.

10. Dispositif de photodétection selon la revendication 1, **caractérisé en ce, que** le réseau d'électrodes (5, 62) forme deux peignes interdigités.

11. Dispositif de photodétection selon la revendication 1, **caractérisé en ce que** le réseau d'électrodes (5, 62) est constitué desdites bandes conductrices qui sont juxtaposées et branchées en potentiel flottant.

12. Dispositif de photodétection selon la revendication 1, **caractérisé en ce que** les bandes conductrices sont en argent, en or ou en aluminium.

13. Dispositif de photodétection selon la revendication 1, **caractérisé en ce qu'**une couche de matériau diélectrique de passivation est déposée sur le réseau d'électrodes.

14. Dispositif de photodétection selon la revendication 13, **caractérisé en ce que** la couche de passivation est en dioxyde de silicium ou en nitrure de silicium.

15. Dispositif de photodétection selon la revendication 1, **caractérisé en ce qu'**une deuxième face du support supporte une électrode d'application d'un champ électrique au dispositif pour changer, par effet électro-optique, la longueur d'onde de résonance de la cavité résonnante.

## Patentansprüche

1. Vorrichtung zur Photodetektion vom Typ MSM, die ausgelegt ist, um ein einfallendes Licht nachzuweisen, und umfassend, in Überlagerung auf einer ersten Seite eines Trägers (1, 51, 81), reflektierende Mittel (2, 52, 82), die einen ersten Spiegel für einen Resonanzhohlraum vom Typ Fabry-Perot formen, eine Schicht eines Materials, das das Licht (3, 53, 83) nicht absorbiert, eine aktive Schicht (4, 54, 84) aus Halbleitermaterial, das das einfallende Licht absorbiert, und ein Netz von Elektroden zur Polarisierung und zur Sammlung des nachgewiesenen Signals, wobei das Netz von Elektroden (5, 62) auf der aktiven Schicht angeordnet ist, wobei das Netz von Elektroden (5, 62) einen zweiten Spiegel für den Resonanzhohlraum bildet, **dadurch gekennzeichnet, dass** das Netz von Elektroden von parallelen leitfähigen Bändern gebildet ist, die regelmäßig gemäß einer Periode beabstandet sind, die geringer als die Wellenlänge des einfallenden Lichts ist, wobei das Licht, das nachgewiesen werden soll, auf die Vorrichtung über das Netz von Elektroden einfällt, wobei die optischen Eigenschaften dieses zweiten Spiegels durch die geometrischen Abmessungen der leitfähigen Bänder bestimmt sind, wobei der Abstand, der den ersten Spiegel vom zweiten Spiegel trennt, bestimmt ist, um zwischen diesen zwei Spiegeln eine Resonanz vom Typ Fabry-Perot für das einfallende Licht zu erhalten.

2. Vorrichtung zur Photodetektion nach Anspruch 1, **dadurch gekennzeichnet, dass** die reflektierenden Mittel, die einen ersten Spiegel formen, aus einem Bragg-Spiegel (2, 52) gebildet sind.

3. Vorrichtung zur Photodetektion nach Anspruch 2, **dadurch gekennzeichnet, dass** der Bragg-Spiegel (2, 52) aus alternierenden Schichten aus AlAs und AlGaAs oder aus alternierenden Schichten aus GaInAsP und InP oder aus alternierenden Schichten von AlGaInAs und AlInAs oder aus alternierenden Schichten aus AlGaAsSb und AlAsSb gebildet ist.

4. Vorrichtung zur Photodetektion nach Anspruch 1, **dadurch gekennzeichnet, dass** die reflektierenden Mittel, die einen ersten Spiegel formen, aus einer metallischen Schicht (82) gebildet sind.

5. Vorrichtung zur Photodetektion nach Anspruch 4, **dadurch gekennzeichnet, dass** die metallische Schicht (82), die den ersten Spiegel bildet, dem einfallenden Licht eine Oberfläche aus Silber, aus Gold oder aus Aluminium bietet.

6. Vorrichtung zur Photodetektion nach Anspruch 1, **dadurch gekennzeichnet, dass** die reflektierenden Mittel, die einen ersten Spiegel formen, aus einem mehrschichtigen dielektrischen Spiegel gebildet sind.

7. Vorrichtung zur Photodetektion nach Anspruch 1, **dadurch gekennzeichnet, dass** die Schicht aus Material, die das Licht (3, 53, 83) nicht absorbiert, aus AlₓGal₁₋ₓAs und die aktive Schicht (4, 54, 84) aus GaAs ist.

8. Vorrichtung zur Photodetektion nach Anspruch 7, **dadurch gekennzeichnet, dass** x im Bereich von 0,35 liegt.

9. Vorrichtung zur Photodetektion nach Anspruch 1, **dadurch gekennzeichnet, dass** die Schicht aus Material, die das Licht (3, 53, 83) nicht absorbiert, aus AlInAs und die aktive Schicht (4, 54, 84) aus InGaAs ist.

10. Vorrichtung zur Photodetektion nach Anspruch 1, **dadurch gekennzeichnet, dass** das Netz von Elektroden (5, 62) zwei Interdigitalkämme formt.

11. Vorrichtung zur Photodetektion nach Anspruch 1, **dadurch gekennzeichnet, dass** das Netz von Elektroden (5, 62) aus den leitfähigen Bändern gebildet ist, die in schwebendem Potenzial verzweigt und nebeneinander gestellt sind.

12. Vorrichtung zur Photodetektion nach Anspruch 1, **dadurch gekennzeichnet, dass** die leitfähigen Bänder aus Silber, aus Gold oder aus Aluminium sind.

13. Vorrichtung zur Photodetektion nach Anspruch 1, **dadurch gekennzeichnet, dass** eine Schicht aus dielektrischem Passivierungsmaterial auf dem Netz von Elektroden abgelegt ist.

14. Vorrichtung zur Photodetektion nach Anspruch 13, **dadurch gekennzeichnet, dass** die Passivierungsschicht aus Siliziumdioxid oder aus Siliziumnitrid ist.

15. Vorrichtung zur Photodetektion nach Anspruch 1, **dadurch gekennzeichnet, dass** eine zweite Seite des Trägers eine Elektrode zur Anlegung eines elektrischen Felds auf die Vorrichtung trägt, um, durch elektrooptischen Effekt, die Resonanzwellenlänge des Resonanzhohlraums zu ändern.

## Claims

1. Photodetector device of the MSM type intended for detecting an incident light and comprising, superimposed on a first face of a support (1, 51, 81), reflecting means (2, 52, 82) forming a first mirror for a resonant cavity of the Fabry-Pérot type, a layer of a material that does not absorb said light (3, 53, 83), an active layer (4, 54, 84) made of semiconductor material absorbing incident light and an grating of electrodes for polarising and collecting the detected signal, the grating of electrodes (5, 62) being arranged on the active layer, with the grating of electrodes (5, 62) constituting a second mirror for the resonant cavity, **characterised in that** the grating of electrodes is comprised of parallel conductive strips regularly spaced according to a period less than the wavelength of the incident light, the light to be detected is incident to the device through the grating of electrodes, the optical characteristics of this second mirror are determined by the geometrical dimensions of said conductive strips, with the distance separating the first mirror from the second mirror being determined in order to obtain between these two mirrors a resonance of the Fabry-Pérot type for the incident light.

2. Photodetector device according to claim 1, **characterised in that** the reflecting means forming a first mirror are comprised of a Bragg mirror (2, 52).

3. Photodetector device according to claim 2, **characterised in that** the Bragg mirror (2, 52) is comprised of alternating layers of AlAs and of AlGaAs or of alternating layers of GaInAsP and of InP or of alternating layers of AlGaInAs and of AlInAs or of alternating layers of AlGaAsSb and of AlAsSb.

4. Photodetector device according to claim 1, **characterised in that** the reflecting means forming a first mirror are comprised of a metal layer (82).

5. Photodetector device according to claim 4, **characterised in that** the metal layer (82) comprising the first mirror offers a silver, gold or aluminium surface to the incident light.

6. Photodetector device according to claim 1, **characterised in that** the reflecting means forming a first mirror are comprised of a multilayer dielectric mirror.

7. Photodetector device according to claim 1, **characterised in that** the non light-absorbing layer of material (3, 53, 83) is made from AlₓGa₁₋ₓAs and the active layer (4, 54, 84) is made from GaAs.

8. Photodetector device according to claim 7, **characterised in that** x is approximately 0.35.

9. Photodetector device according to claim 1, **characterised in that** the non light-absorbing layer of material (3, 53, 83) is made of AlInAs and the active layer (4, 54, 84) is made of InGaAs.

10. Photodetector device according to claim 1, **characterised in that** the grating of electrodes (5, 62) forms two inter-engaged combs.

11. Photodetector device according to claim 1, **characterised in that** the grating of electrodes (5, 62) is comprised of said conductive strips which are juxtaposed and connected as floating potential.

12. Photodetector device according to claim 1, **characterised in that** the conductive strips are made of silver, gold or aluminium.

13. Photodetector device according to claim 1, **characterised in that** a layer of passivation dielectric material is deposited on the grating of electrodes.

14. Photodetector device according to claim 13, **characterised in that** the passivation layer is made from silicon dioxide or from silicon nitride.

15. Photodetector device according to claim 1, **characterised in that** a second face of the support supports an electrode for the application of an electric field to the device for changing, via electro-optical effect, the resonance wavelength of the resonant cavity.
